(19) Europäisches Patentamt
European Patent Office
Office européen des brevets

(11) **EP 1 632 746 B1**

(12) **EUROPÄISCHE PATENTSCHRIFT**

(45) Veröffentlichungstag und Bekanntmachung des Hinweises auf die Patenterteilung:
**03.10.2007 Patentblatt 2007/40**

(51) Int Cl.:
***G01B 11/06*** *(2006.01)*

(21) Anmeldenummer: **04021243.3**

(22) Anmeldetag: **07.09.2004**

(54) **Verfahren zur Bestimmung von physikalischen Eigenschaften einer optischen Schicht oder eines Schichtsystems**

Method of determining physical parameters of an optical layer or a layer system

Procédé pour déterminer des paramètres physiques d'une couche optique ou d'un ensemble de couches

(84) Benannte Vertragsstaaten:
**AT BE BG CH CY CZ DE DK EE ES FI FR GB GR HU IE IT LI LU MC NL PL PT RO SE SI SK TR**

(43) Veröffentlichungstag der Anmeldung:
**08.03.2006 Patentblatt 2006/10**

(73) Patentinhaber: **Applied Materials GmbH & Co. KG 63755 Alzenau (DE)**

(72) Erfinder:
• **Lotz, Hans-Georg, Dr.**
  **63584 Gründau-Rothenbergen (DE)**

• **Schroeder, Jürgen**
  **63538 Grosskrotzenburg (DE)**

(74) Vertreter: **GROSSE BOCKHORNI SCHUMACHER Patent- und Rechtsanwälte Elsenheimerstrasse 49 80687 München (DE)**

(56) Entgegenhaltungen:
**EP-A- 0 644 399      US-A- 5 999 267
US-A1- 2003 147 085   US-B1- 6 485 872**

EP 1 632 746 B1

**Beschreibung**

Die vorliegende Erfindung betrifft ein Verfahren zur Bestimmung von physikalischen Eigenschaften einer optischen Schicht oder eines Schichtsystems mittels Transmissions- und/oder Reflexionsmessung. Ein derartiges Verfahren ist z.B. aus der US-2003/0147085, US-5999267 oder US-6485872 bekannt.

Die Beschichtung von Substraten, insbesondere Glassubstraten mit optisch wirksamen Schichten ist weit verbreitet. Beispiele hierfür sind sog. low-E bzw. Wärmeschutzschichten für Architekturverglasungen, Antireflexionsschichten beispielsweise für Bildschirme und dgl.. Derartige Schichten werden beispielsweise unter Vakuumbedingungen durch SputterVerfahren abgeschieden, wobei aus wirtschaftlichen Gründen vorzugsweise großflächige Substrate zum Einsatz kommen.

Hierbei ist es wichtig, dass die abgeschiedenen Schichten qualitativ überprüft werden können, um sicher zu stellen, dass die gewünschten physikalischen Eigenschaften, insbesondere auch homogen über die gesamte Substratfläche erreicht werden. Unter physikalischen Eigenschaften werden hierbei beispielsweise die Schichtdicke, das Transmissions- oder Reflexionsvermögen, die Brechungszahl und dgl. verstanden.

Beispielsweise wird im Stand der Technik die gleichmäßige Schichtdicke von abgeschiedenen Schichten dadurch untersucht, dass bei einem vorher entsprechend präparierten Substrat das Substrat nach der Abscheidung der Schicht beispielsweise mit einem Profilometer mechanisch vennessen wird. Bei großen Substraten, wie z. B. Architekturverglasungen sind hierfür beispielsweise 2000 Messpunkte verteilt über dem Substrat notwendig, was bei einer mechanischen Messung einen erheblichen und tatsächlich nicht durchführbaren Aufwand bedeutet.

Es ist deshalb Aufgabe der vorliegenden Erfindung, ein Verfahren zur qualitativen Überprüfung von Schichten bereit zu stellen, welches effektiv und einfach durchzuführen ist. Insbesondere soll das Verfahren Aussagen über die Homogenität der Schicht über dem Beschichtungsbereich erlauben. Nach einem weiteren Aspekt soll ein Verfahren bereitgestellt werden, welches die effektive und schnelle Ermittlung der Schichtdicken und insbesondere der Schichtdickenverteilung bei großflächigen Substraten ermöglicht.

Diese Aufgabe wird gelöst durch ein Verfahren mit den Merkmalen des Anspruchs 1. Vorteilhafte Ausgestaltungen und Weiterbildungen sind Gegenstand der abhängigen Ansprüche.

Die Erfindung macht sich die Tatsache zu Nutze, dass die Veränderung des Brechungsindex einer Schicht oder eines Schichtsystems durch die Beschichtungsbedingungen ebenso wie die Veränderung des Extinktionskoeffizienten durch eine wellenlängennabhängige Veränderungskonstante $K_n$ bzw. $K_k$ oder additive Konstante beschrieben werden kann.

Diese Veränderungskonstanten $K_n$ und $K_k$ können kann in einfacher Weise durch Subtraktion eines theoretischen Werts oder Referenzwerts von einem aktuell bei der zu untersuchenden Schicht durch Reflexions- und/oder Transmissionsmessungen ermittelten Wert für den Brechungsindex und/oder Extinktionskoeffizienten bestimmt werden. Die so bestimmten Veränderungskonstanten sind somit ein Maß für die Abweichung des Brechungsindex (Brechungsindex-Offset) oder Extinktionskoeffizienten (Extinktionskoeffizient-Offset) von einem theoretischen oder Referenzwert.

Darüber hinaus kann auch die Abweichung der Schichtdicke von einem Zielwert durch eine additive Komponente dargestellt werden.

Entsprechend kann bei Bestimmung einer oder mehrerer Veränderungskonstanten an mehreren Stellen über der Beschichtungsfläche bzw. der beschichteten Substratfläche mittels der Veränderungskonstanten eine Aussage über die optische Homogenität der Schicht getroffen werden.

Ausgehend von der Charakterisierung der Schicht durch die Veränderungskonstanten kann bei einer bevorzugten Ausgestaltung bzw. Weiterbildung der vorliegenden Erfindung die Schichtdicke und die optischen Eigenschaften, wie Brechungsindex und Extinktionskoeffizient, der Schicht bzw. des Schichtsystems in einfacher Weise durch Angleichung von experimentellen Reflexions- und/oder Transmissionsdaten und theoretisch aus Schichtdicke, Brechungsindex und Extinktionskoeffizienten berechneten theoretischen Reflexions- und/oder Transmissionswerten mittels nichtlinearer Optimierungsalgorithmen ermittelt werden, wobei hierzu einerseits theoretische Werte oder Referenzwerte für den Brechungsindex $n_0$ und Extinktionskoeffizienten $k_0$ ergänzt um die additive Komponente der Veränderungskonstanten $K_n$ und $K_k$ und andererseits die zu erwartende Schichtdicke (Zielschichtdicke) $d_0$ addiert mit der Veränderungskonstanten $K_d$ als Start- bzw. Anfangswert und Eingangsgrößen für die nichtlineare Optimierung herangezogen werden. Durch die Verwendung der Veränderungskonstanten des Brechungsindex $K_n$ und des Extinktionskoeffizienten $K_k$ sowie $K_d$ für die Schichtdicke für die Optimierung anstelle der vielfältig abhängigen Werte für den Brechungsindex und den Extinktionskoeffizienten selbst, wird eine deutliche Vereinfachung und Beschleunigung der Optimierung erreicht. Die hierzu verwendeten nichtlinearen Optimierungsalgorithmen sind aus der Mathematik allgemein bekannt und bedürfen hier keiner näheren Erläuterung. Als Beispiele hierfür können das Simplex-Verfahren von Nelder und Mead, der Powell's Algorithmus oder die Optimierung durch einen genetischen Algorithmus genannt werden.

Die Referenzwerte oder theoretischen Werte für den Brechungsindex $n_0$ und/oder Extinktionskoeffizienten $k_0$ können vorzugsweise experimentell durch spektrale Ellipsometrie an einer Referenzschicht bestimmt werden. Grundsätzlich ist es aber auch möglich hier Literaturdaten einzusetzen. Durch die Veränderungskonstanten $K_n$, $K_k$ und $K_d$ wird die Abweichung der optischen Eigenschaften der tatsächlich vorliegenden Schicht von den Referenzwerten beschrieben, wobei durch die nichtlineare Optimierung dieser Konstanten eine einfache und eindeutige Abschätzung der tatsächlich vorliegenden Werte möglich ist.

Vorzugsweise geht die nichtlineare Optimierung hierbei von einer Bewertungsfunktion aus, für die ein Minimum bestimmt werden muss. Durch die Verwendung der additiven Veränderungskonstanten $K_n$, $K_k$ und $K_d$ wird hierbei sichergestellt, dass keine physikalisch unsinnigen Lösungen, beispielsweise durch Auffinden eines lokalen Minimas, gefunden werden.

Als Bewertungsfunktion wird vorzugsweise die Summe der Abstandsquadrate zwischen gemessenen Reflexions- und/oder Transmissionswerten und theoretischen Reflexions- und/oder Transmissionswerten herangezogen.

Vorzugsweise wird die Veränderungskonstante bzw. die Veränderungskonstanten durch mehrere Messungen an derselben Schichtstelle und Mittelwertbildung bestimmt, wobei insbesondere die Messungen mit unterschiedlichen Wellenlängen oder Wellenlängenbereichen durchgeführt werden.

Nach einer weiteren vorteilhaften Ausgestaltung wird die nichtlineare Optimierung zur Abschätzung der Schichtdicke weiterhin dadurch abgewandelt, dass eine Serie von Start- bzw. Anfangswerten für die Schichtdicke verwendet wird. Damit wird erreicht, dass bei der Optimierung nicht nur ein Minimum der zu dem nichtlinearen Optimierungsalgorithmus zugehörigen Bewertungsfunktion ermittelt wird, sondern für jeden Start- bzw. Anfangswert ein eigener minimaler Wert, wobei dann aus diesen der kleinste Wert ausgesucht wird. Damit wird erreicht, dass bei großen Schichtdickenschwankungen, wie sie bei großflächigen Beschichtungen auftreten können, nicht durch Auffinden von lokalen Minima der Bewertungsfunktion physikalisch falsche oder sinnlose Ergebnisse ermittelt werden, sondern durch die Iteration des Anfangs- bzw. Startwerts und Auswahl des absoluten Minimums gewährleistet wird, dass nur physikalisch sinnvolle Lösungen aufgefunden werden.

Weitere Vorteile, Kennzeichen und Merkmale der vorliegenden Erfindung ergeben sich aus der nachfolgenden detaillierten Beschreibung von Ausführungsbeispielen anhand der beigefügten Diagramme. Die Figuren zeigen in

Fig. 1 die Abhängigkeit des Brechungsindex n von der Wellenlänge bei $TiO_2$-Schichten, die bei Atmosphären mit unterschiedlichen Sauerstoffgehalten abgeschieden worden sind;

Fig. 2 die Abhängigkeit des Extinktionskoeffizienten k von der Wellenlänge bei $TiO_2$-Schichten aus Fig. 1, die bei Atmosphären mit unterschiedlichen Sauerstoffgehalten abgeschieden worden sind;

Fig. 3 ein Diagramm mit der Schichtdickenverteilung einer ITO-Schicht auf einem Glassubstrat; und in

Fig. 4 ein Diagramm mit einer Schichtdickenverteilung für eine SiliziumSchicht auf einem großflächigen Substrat.

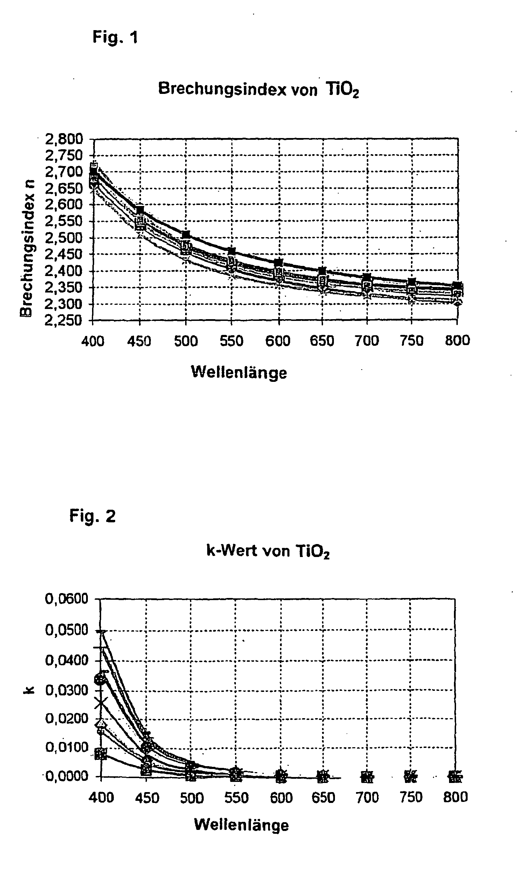

In Fig. 1 ist ein Diagramm gezeigt, welches die Abhängigkeit des Brechungsindex n von der Wellenlänge des verwendeten Lichts für eine $TiO_2$-Schicht zeigt. Die verschiedenen Kurven sind für $TiO_2$-Schichten aufgenommen, die unter verschiedenen Beschichtungsbedingungen mit unterschiedlichem Anteil an Sauerstoff in der Beschichtungsatmosphäre abgeschieden worden sind. Aus den verschiedenen Kurven ist zu entnehmen, dass abhängig von den Beschichtungsbedingungen der Brechungsindex n durch eine additive Konstante verändert wird, je nach dem wie die Beschichtungsbedingungen vorliegen.

In gleicher Weise zeigt die Fig. 2 die Abhängigkeit des Extinktionskoeffizienten k für verschiedene $TiO_2$-Schichten von der Wellenlänge des verwendeten Lichts. Auch hier kann die sauerstoffbedingte Veränderung des Extinktionskoeffizienten für die unterschiedlich abgeschiedenen $TiO_2$-Schichten zumindest im Bereich unterhalb einer Wellenlänge von 600 nm durch eine additive Konstante beschrieben werden.

Entsprechend lässt sich sowohl die Veränderung des Brechungsindex n als auch des Extinktionskoeffizienten k durch unterschiedliche Abscheidebedingungen für die Schicht durch jeweils eine additive Konstante $K_n$ bzw. $K_k$ beschreiben. Die Konstante $K_n$ für die Änderung des Brechungsindex n lässt sich in einfacher Weise dadurch bestimmen, dass ein bekannter (theoretischer) oder grundsätzlich ermittelter (Referenzwert) Wert für den Brechungsindex $n_o$ von einem aktuell bestimmten Wert für eine zu untersuchende Schicht abgezogen wird bzw. mehrere grundsätzlich vorliegende oder bekannte Brechungsindizes $n_o$ für bestimmte Wellenlängen von den aktuell ermittelten Werten der Brechungsindizes n für die jeweiligen Wellenlängen abgezogen wird. Der grundsätzlich ermittelte Referenzwert $n_0$ kann beispielsweise mittels der spektralen Ellipsometrie gewonnen werden. Die Ermittlung des aktuellen Brechungsindex n für eine zu untersuchende Schicht kann durch Transmissions und/oder Reflexionsmessungen erfolgen. Aus der Vielzahl der Veränderungskonstanten für die verschiedenen Wellenlängen kann ein Mittelwert für die additive Konstante (Veränderungskonstante) bestimmt werden.

In gleicher Weise kann auch eine Veränderungskonstante $K_k$ (additive Konstante) für den Extinktionskoeffizienten k ermittelt werden, wobei hier ebenfalls grundsätzlich bekannte Werte für den Extinktionskoeffizienten $k_0$ der zu untersuchenden Schicht von den aktuell bestimmten Werten des Extinktionskoeffizienten k der zu untersuchenden Schicht subtrahiert werden.

Die Veränderungskonstanten $K_n$ und $K_k$ stellen ein Maß für die Abweichung der optischen Eigenschaften der Beschichtung bzw. der mit der Beschichtung beschichteten Substrate, beispielsweise Glasscheiben, dar. Es gilt somit:

$$n = n_0 + K_n$$

$$k = k_0 + K_k$$

Durch Bestimmung der Veränderungskonstanten in einer Vielzahl von Messstellen verteilt über das beschichtete Substrat, beispielsweise großformatigen Architekturverglasungen, kann eine Information über die Homogenität der Glasoberfläche bzw. der Beschichtung erhalten werden.

Nach einem weiteren Aspekt wird bei dem erfindungsgemäßen Verfahren aus dem für die Schicht grundsätzlich bekannten Brechungsindex $n_0$ und Extinktionskoeffizienten $k_0$ die Schichtdicke d bestimmt. Hierzu werden nichtlineare Optimierungsalgorithmen eingesetzt, wobei jedoch zur Optimierung lediglich die Veränderungskonstanten des Brechungsindex $K_n$ und des Extinktionskoeffizienten $K_k$ sowie die Schichtdicke, die ebenfalls mit einer additiven Konstante $K_d$ addiert zur Zielschichtdicke $d_0$ ($d = d_0 + k_d$) beschrieben werden kann, herangezogen werden und nicht der Brechungsindex oder der Extinktionskoeffizient an sich mit seinen Abhängigkeiten von verschiedenen Einflüssen. Dadurch kann eine Reduzierung der veränderbaren Parameter erhalten werden, welche die Durchführung der nichtlinearen Optimierungsalgorithmen deutlich vereinfacht und erleichtert.

Nach einer bevorzugten Ausführungsform werden bei der zu untersuchenden Schicht bzw. des Schichtsystems an einer Vielzahl von Stellen verteilt über der Schicht Reflexions- und Transmissionsmessungen durchgeführt, so dass Daten bezüglich der Reflexion und Transmission an jeder Stelle für ein bestimmtes Wellenlängenspektrum des verwendeten Lichts vorliegen. Aus den bekannten Referenzwerten für den Extinktionskoeffizienten $k_0$, den Brechungsindex $n_0$ und der Zielschichtdicke $d_0$ können für die verschiedenen Wellenlängen des Wellenlängenspektrums theoretische Reflexions- und Transmissionswerte errechnet werden. Mittels nichtlinearer Optimierungsalgorithmen können die theoretisch berechneten Reflexions- und Transmissionsdaten an die gemessenen Daten angepasst werden, wobei die Veränderung des Brechungsindex, des Extinktionskoeffizienten und der Schichtdicke durch die additiven Veränderungskonstanten $K_n$, $K_k$ und $K_d$ beschrieben werden. Die Optimierung erfolgt somit bezüglich der Veränderungskonstanten, so dass aus den Veränderungskonstanten die tatsächlich vorliegenden Werte, insbesondere hinsichtlich der Schichtdicke abgeschätzt werden können.

Als nichtlineare Optimierungsverfahren können die aus der Mathematik bekannten Optimierungsalgorithmen eingesetzt werden, wie beispielsweise das Simplex-Verfahren von Nelder und Mead, der Powell's Algorithmus oder die Optimierung durch einen genetischen Algorithmus.

Grundsätzlich beruht die nichtlineare Optimierung auf dem Auffinden eines Minimums für eine Bewertungsfunktion, die nach dem bevorzugten Ausführungsbeispiel durch die Summe der Abstandsquadrate zwischen gemessenen Reflexions- und/oder Transmissionsdaten und theoretisch berechneten Reflexions- und/oder Transmissionsdaten definiert ist, wobei die theoretischen Reflexions- und/oder Transmissionsdaten eine Funktion des Extinktionskoeffizienten, des Brechungsindex und der Schichtdicke sind, in die wiederum die theoretischen Werte bzw. die Zieldicke addiert um die Veränderungskonstanten eingesetzt werden. Die als optimal ermittelten Veränderungskonstanten geben dann ein Maß für die optische Güte oder zusammen mit den Referenzwerten eine Abschätzung der optischen Eigenschaften, wie insbesondere der Schichtdicke, an.

Für das Optimierungsverfahren unter Verwendung von nichtlinearen Optimierungsalgorithmen muss ein Anfangs- oder Startwert für die Schichtdicke, die sog. Zielschichtdicke, gewählt werden. In einer weiteren Verbesserung des Verfahrens wird die Optimierung für eine Reihe von Start- oder Anfangswerten durchgeführt, so beispielsweise bei einer $TiO_2$-Schicht oder einer Indiumzinnoxidschicht (ITO-Schicht) mit einer Reihe von Werten, die zwischen einem minimalen und maximal zu erwartenden Wert für die Schichtdicke liegen. Beispielsweise könnte bei einer ITO-Schicht die Schichtdicke zwischen minimal 80 nm und maximal 200 nm erwartet werden, so dass verschiedene Optimierungen mit Startwerten von 80, 100, 120, 140, 160, 180 und 200 nm durchgeführt werden, um dann für alle diese Startwerte das Minimum aller Bewertungsfunktionen zu bestimmen, so dass eine optimale Annäherung an die zu bestimmende Schichtdicke erfolgt.

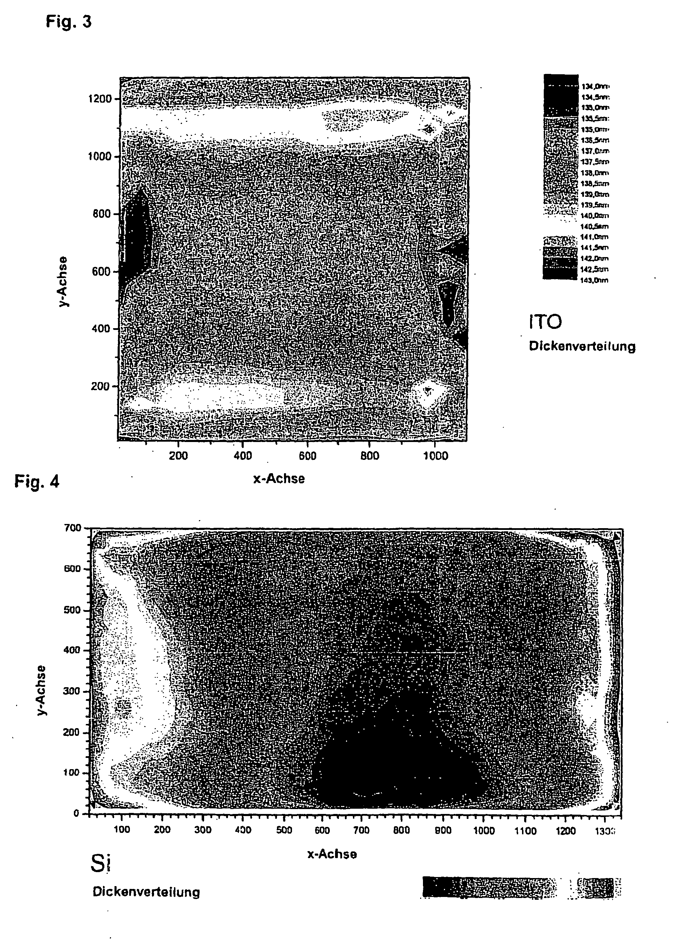

Die Diagramme in den Figuren 3 und 4 beschreiben das Ergebnis einer derartigen Bestimmung der Schichtdickenverteilung über großflächige Glassubstrate bei einer ITO-Schicht (Fig. 3) und einer Si-Schicht (Fig. 4). Die Substrate weisen hierbei eine Größe von über 1000 x 1200 mm bzw. 700 x 1300 mm auf.

Durch die vereinfachte Optimierung mit den Veränderungskonstanten $K_n$ und $K_k$ für den Brechungsindex n und den Extinktionskoeffizienten k bzw. $K_d$ für die Schichtdicke d ist eine schnelle Bestimmung der Schichtdickenverteilung durch viele Transmissions- und Reflexionsmessungen an einer Vielzahl von über der Substratfläche verteilten Messpunkten und deren Auswertung möglich. Darüber hinaus ergeben die dabei ermittelten Veränderungskonstanten $K_n$ und $K_k$ einen Überblick über die Homogenität der optischen Schichteigenschaften.

Wie sich aus den Figuren 3 und 4 ergibt, ermöglicht das erfindungsgemäße Verfahren insbesondere durch die Verwendung einer Vielzahl von Start- bzw. Anfangswerten für die nichtlineare Optimierung eine automatische Schichtdickenbestimmung, wobei physikalisch sinnlose Lösungen wie physikalisch nicht zu erwartende Schichtdickensprünge, vermieden werden. Dies gilt insbesondere auch für großflächige Substrate, bei denen die Schichtdicken in einem größeren Bereich schwanken können, da durch das Verwenden von mehreren Start- bzw. Anfangswerten für die nichtlineare Optimierung das Auffinden von lediglich lokalen Minima der Bewertungsfunktion vermieden wird, was zu falschen Annäherungen an die Schichtdicke führen würde.

**Patentansprüche**

1. Verfahren zur qualitativen Überprüfung einer optischen Schicht oder eines Schichtsystems mittels spektraler Transmissions- und/oder Reflexionsmessung
   **dadurch gekennzeichnet, dass**

   • aktuelle Transmissions- und/oder Reflexionswerte gemessen werden,
   • für die Schicht oder das Schichtsystem entsprechend dem Spektrum der Transmissions- und/oder Reflexionsmessung Referenzwerte für die wellenlängenabhängigen Brechungsindizes $n_o$ und/oder Extinktionskoeffizienten $k_o$ aus bekannten Werten ausgewählt oder experimentell bestimmt werden,
   • aus den Referenzwerten für Brechungsindex $n_o$ und Extinktionskoeffizienten $k_o$ und einem Zielwert $d_o$ für die Schichtdicke theoretische Reflexions- und/oder Transmissionswerte ermittelt werden,
   • die theoretischen Reflexions- und/oder Transmissionswerte an die gemessenen Reflexions- und/oder Transmissionswerte angeglichen werden, wobei
   • die die Schicht charakterisierende Abweichung der Brechungsindizes n und/oder Extinktionskoeffizienten k von den Referenzwerten durch jeweils eine wellenlängenunabhängige Veränderungskonstante $K_n$ und $K_k$ bestimmt wird.

2. Verfahren nach Anspruch 1,
   **dadurch gekennzeichnet, dass**
   theoretischen Reflexions- und/oder Transmissionswerte mittels nichtlinearer Optimierung an die gemessenen Reflexions- und/oder Transmissionswerte angepasst werden.

3. Verfahren nach Anspruch 2,
   **dadurch gekennzeichnet, dass**
   für die nichtlineare Optimierung die Referenzwerte für Brechungsindex $n_o$ und Extinktionskoeffizienten

$k_o$ sowie die Zielschichtdicke $d_o$ jeweils versehen mit einer Veränderungskonstanten $K_n$, $K_k$ und $K_d$ als Startwerte verwendet werden, wobei die Optimierung bezüglich der Veränderungskonstanten $K_n$, $K_k$ und $K_d$ erfolgt.

4. Verfahren nach Anspruch 3,
   **dadurch gekennzeichnet, dass**
   aus mehreren Messungen derselben Schichtstelle insbesondere mit unterschiedlichen Wellenlängen des verwendeten Lichts die mittleren Veränderungskonstanten $K_n$, $K_k$ und $K_d$ bestimmt werden.

5. Verfahren nach einem der vorhergehenden Ansprüche,
   **dadurch gekennzeichnet, dass**
   an mehreren Schichtstellen die Veränderungskonstanten $K_n$, $K_k$ und $K_d$ bestimmt werden und zur Bestimmung der optischen Homogenität über der Schichtfläche verwendet werden.

6. Verfahren nach einem der Ansprüche 2 bis 5,
   **dadurch gekennzeichnet, dass**
   zur Optimierung das Minimum einer Bewertungsfunktion bestimmt wird.

7. Verfahren nach Anspruch 6,
   **dadurch gekennzeichnet, dass**
   als Bewertungsfunktion die Summe der Abstandsquadrate zwischen gemessener Reflexions- und/oder Transmissionswerte und theoretischer Reflexions- und/oder Transmissionswerte verwendet wird.

8. Verfahren nach einem der Ansprüche 2 bis 7,
   **dadurch gekennzeichnet, dass**
   zur Optimierung als Startwert für den Optimierungsalgoritlunus eine Serie von Zielschichtdicken verwendet wird, wobei dasjenige Ergebnis ausgewählt wird, das einen minimalen Wert für die Bewertungsfunktion liefert.

9. Verfahren nach Anspruch 8,
   **dadurch gekennzeichnet, dass**
   für die Serie von Zielschichtdicken eine Mehrzahl von Werten verwendet wird, die insbesondere in gleichen Intervallen zwischen einem für die zu bestimmende Schicht technisch möglichen und zu erwartenden Minimal- und Maximalwert liegen.

10. Verfahren nach einem der vorhergehenden Ansprüche,
    **dadurch gekennzeichnet, dass**
    die Referenzwerte für Brechungsindex und Extinktionskoeffizienten durch spektrale Ellipsometrie gewonnen werden.

11. Verfahren nach einem der vorhergehenden Ansprüche,

**dadurch gekennzeichnet, dass**
das Verfahren auf einer programmtechnisch eingerichteten Datenverarbeitungsanlage durchgeführt wird, und insbesondere nach Eingabe des Referenzwertes für den Brechungsindex und/oder den Extinktionskoeffizienten der zu bestimmenden Schicht oder des Schichtsystems und/oder der minimalen und maximalen zu erwartenden Schichtdicke insbesondere inklusive der Steuerung der durchzuführenden Messungen vollautomatisch abläuft.

12. Computerprogrammprodukt; welches mit einer Datenverarbeitungsanlage derart zusammenwirken kann und durch die Datenverarbeitungsanlage ausführbare Befehle umfasst, so dass das Verfahren nach einem der vorhergehenden Ansprüche durchgeführt wird.

**Claims**

1. Method for the qualitative examination of an optical layer or a layer system by means of spectral transmission and/or reflection measurement,
**characterized by** the fact that

   • instantaneous transmission and/or reflection values are measured,
   • for the layer or the layer system corresponding to the spectrum of the transmission and/or reflection measurement, reference values for the wavelength-dependent refractive indices $n_0$, and/or extinction coefficients $k_0$ are selected or experimentally determined from known values,
   • from the reference values for refractive index $n_0$ and extinction coefficients $k_0$ and a target value $d_0$ for the layer thickness, theoretical reflection and/or transmission values are determined,
   • the theoretical reflection and/or transmission values are adapted to the measured reflection and/or transmission values, with
   • the layer-characterizing deviation of the refractive indices n and/or extinction coefficients k being determined from the reference values by in each case a wavelength-independent change constant $K_n$ and $K_k$.

2. Method in accordance with claim 1,
**characterized by** the fact that
theoretical reflection and/or transmission values are adjusted by means of nonlinear optimization to the measured reflection and/or transmission values.

3. Method in accordance with claim 2,
**characterized by** the fact that
for the nonlinear optimization, the reference values for refractive index $n_0$ and extinction coefficient $k_0$ as well as the target layer thickness $d_0$, each provid-
ed with a change constant of $K_n$, $K_k$ and $K_d$, are used as initial values, with the optimization taking place with reference to the change constants $K_n$, $K_k$ and $K_d$.

4. Method in accordance with claim 3,
**characterized by** the fact that
the average change constants $K_n$, $K_k$ and $K_d$ are determined from several measurements taken at the same layer site, especially with different wavelengths of the light employed.

5. Method in accordance with any of the previous claims,
**characterized by** the fact that
the change constants $K_n$, $K_k$ and $K_d$ are determined at several layer sites and are used for the determination of the optical homogeneity over the layer surface.

6. Method in accordance with claims 2 to 5,
**characterized by** the fact that
the minimum of a valuation function is determined for the purpose of optimization.

7. Method in accordance with claim 6,
**characterized by** the fact that
the sum of the squares of the differences between measured reflection and/or transmission values and theoretical reflection and/or transmission values serves as valuation function.

8. Method in accordance with claims 2 to 7,
**characterized by** the fact that
for the purpose of the optimization, a series of target layer thicknesses serves as initial value for the optimization algorithm, with that result being selected which returns a minimum value for the valuation function.

9. Method in accordance with claim 8,
**characterized by** the fact that
a plurality of values is used for the series of target layer thicknesses, said values lying especially in the same intervals between the technically possible and expected minimum and maximum value for the layer to be determined.

10. Method in accordance with any of the previous claims,
**characterized by** the fact that
the reference values for the refractive index and the extinction coefficient are obtained by spectral ellipsometry.

11. Method in accordance with any of the previous claims,
**characterized by** the fact that
the method is performed on a program-technically configured data-processing system, and runs fully automatically, especially after input of the reference value for the refractive index and/or the extinction coefficient of the layer to be determined or of the layer system and/or the minimum and maximum layer thickness to be expected, especially including control of the measurements to be performed.

12. Computer program product that can interact with a data-processing system in such a manner and comprises commands executable by the data-processing system, such that the method is performed in accordance with any of the previous claims.

**Revendications**

1. Procédé pour le contrôle qualitatif d'une couche optique ou d'un ensemble de couches au moyen d'une mesure de transmission et/ou de réflexion spectrale, **caractérisé en ce que** :

   - on mesure les valeurs de transmission et/ou de réflexion actuelles,
   - pour la couche ou l'ensemble de couches, en fonction du spectre des mesures de transmission et/ou de réflexion, on sélectionne parmi des valeurs connues ou on détermine expérimentalement des valeurs de référence pour les indices de réfraction $n_o$ et/ou les coefficients d'extinction $k_o$ qui dépendent des longueurs d'ondes,
   - parmi les valeurs de référence pour l'indice de réfraction $n_o$ et les coefficients d'extinction $k_o$ et avec une valeur cible $d_o$ pour l'épaisseur de couche, on définit des valeurs de réflexion et/ou de transmission théoriques,
   - les valeurs de réflexion et/ou de transmission théoriques sont adaptées aux valeurs de réflexion et/ou de transmission mesurées, et
   - l'écart entre les indices de réfraction n et/ou les coefficients d'extinction k et les valeurs de référence, écart qui caractérise la couche, est défini respectivement par une constante de variation $K_n$ et $K_k$ indépendante des longueurs d'ondes.

2. Procédé selon la revendication 1, **caractérisé en ce que** les valeurs de réflexion et/ou de transmission théoriques sont adaptées aux valeurs de réflexion et/ou de transmission mesurées au moyen d'une optimisation non linéaire.

3. Procédé selon la revendication 2, **caractérisé en ce que** pour l'optimisation non linéaire, on utilise comme valeurs de démarrage les valeurs de référence pour l'indice de réfraction $n_o$ et les coefficients d'extinction $k_o$ ainsi que l'épaisseur de couche cible $d_o$, respectivement assorties d'une constante de variation $K_n$, $K_k$, et $K_d$, l'optimisation s'effectuant en correspondance avec les constantes de variation $K_n$, $K_k$ et $K_d$ .

4. Procédé selon la revendication 3, **caractérisé en ce qu'**on détermine les constantes de variation $K_n$, $K_k$ et $K_d$ moyennes à partir de plusieurs mesures du même ensemble de couches, en particulier avec des longueurs d'ondes distinctes de la lumière utilisée.

5. Procédé selon l'une quelconque des revendications précédentes, **caractérisé en ce qu'**on détermine les constantes de variation $K_n$, $K_k$ et $K_d$ avec plusieurs ensembles de couches et on les utilise pour déterminer l'homogénéité optique des surfaces des couches.

6. Procédé selon l'une quelconque des revendications 2 à 5, **caractérisé en ce que** pour effectuer l'optimisation on détermine le minimum d'une fonction d'évaluation.

7. Procédé selon la revendication 6, **caractérisé en ce que**, comme fonction d'évaluation, on utilise la somme des carrés des écarts entre les valeurs de réflexion et/ou de transmission mesurées et les valeurs de réflexion et/ou de transmission théoriques.

8. Procédé selon l'une quelconque des revendications 2 à 7, **caractérisé en ce que** pour effectuer l'optimisation, on utilise comme valeur de démarrage une série d'épaisseurs de couche cibles, et on sélectionne le résultat qui donne une valeur minimale pour la fonction d'évaluation.

9. Procédé selon la revendication 8, **caractérisé en ce que** pour la série d'épaisseurs de couche cibles, on utilise plusieurs valeurs, en particulier des valeurs qui se situent à intervalles égaux entre des valeurs minimale et maximale escomptées techniquement possibles pour la couche à contrôler.

10. Procédé selon l'une quelconque des revendications précédentes, **caractérisé en ce que** les valeurs de référence pour l'indice de réfraction et les coefficients d'extinction sont acquises par ellipsométrie spectrale.

11. Procédé selon l'une quelconque des revendications précédentes, **caractérisé en ce que** le processus est exécuté sur un dispositif de traitement de données agencé techniquement avec programmation, et se déroule entièrement automatiquement, en particulier selon la valeur de référence pour l'indice de réfraction et/ou les coefficients d'extinction de la couche ou de l'ensemble de couches à contrôler et/ou les valeurs minimale et maximale pour l'épaisseur de couche escomptée, et en particulier selon le pilotage des mesures à effectuer.

**12.** Produit de programmation d'ordinateur qui peut travailler avec un dispositif de traitement de données et comprend des instructions exécutables par le dispositif de traitement de données, en sorte que le procédé se déroule selon l'une quelconque des revendications précédentes.

**Fig. 1**

**Brechungsindex von TiO$_2$**

**Fig. 2**

**k-Wert von TiO$_2$**

**Fig. 3**

ITO
Dickenverteilung

**Fig. 4**

Si
Dickenverteilung

**IN DER BESCHREIBUNG AUFGEFÜHRTE DOKUMENTE**

**In der Beschreibung aufgeführte Patentdokumente**

- US 20030147085 A
- US 5999267 A
- US 6485872 B